# EUROPEAN PATENT SPECIFICATION

(11) **EP 2 378 850 B1**
(45) Date of publication and mention of the grant of the patent: **29.05.2013**
(21) Application number: 10004078.1
(22) Date of filing: 16.04.2010
(51) Int. Cl.: H05K 9/00, F03D 11/00, H02G 3/04

(54) **Tower with EMC protection system**
Turm mit EMV-Schutzsystem
Tour avec système de protection EMC

(43) Date of publication of application: 19.10.2011
(73) Proprietor: Siemens Aktiengesellschaft, 80333 München (DE)
(72) Inventor: Lewke, Bastian, 7400 Herning (DK)

(56) References cited:
- EP-A2- 1 036 937
- FR-A1- 2 760 907
- GB-A- 595 513
- US-A- 3 351 699
- US-A1- 2009 272 557
- DEL PINO LOPEZ J C ET AL: "Parametric analysis of magnetic field mitigation shielding for underground power cables" RENEWABLE ENERGY AND POWER QUALITY JOURNAL, XX, XX, no. 5, 1 March 2007 (2007-03-01), pages 1-8, XP008124731

## Description

The invention relates to a tower with an electromagnetic compatibility (EMC) protection system for electrical cables inside of a tower.

Towers like for example towers of wind turbines are subjected to strikes of lightning which induce lightning current into the tower and/or structures mounted onto the towers. Often, especially for wind turbine steel towers are used. The lightning current flows through the tower to the ground. Electrical cables running inside the tower are protected against electromagnetic fields by the Faraday cage of the steel tower.

Towers made of concrete or having a lattice structure do not provide the Faraday cage and therefore not the same shielding against electromagnetic fields. A lightning current is conducted by one or more down-conductors to the ground. The down-conductors are arranged inside the tower. The electromagnetic field resulting from the flowing lightning current induces high voltages and currents in the electrical cables running inside the tower. The induced currents can damage or destroy electric or electronic systems which are connected to the cables. This problem is even more severe for high towers like example wind turbine towers with a height of 100 meters as the electrical cables form very long loops.

U-shaped shields for shielding the magnetic field mitigation from underground power cables are known from the article "Parametric analysis of magnetic field mitigation shielding for underground power cables", J.C. del Pino López, P. Cruz Romero and P. Dular, Department of Electrical Engineering, University of Seville. The article shows how effective the shielding in the underground protects the surrounding from magnetic fields.

US 2009/272557 A1 discloses an earthing system for a wind turbine connected to a utility grid. A connection to an electrically earth potential is established from one defined space within the wind turbine for electric systems of the wind turbine like power systems, control systems and safety systems like a lightning protection system.

EP 1 036 937 A2 discloses a lightning protection system for a wind power generation installation with a conductor ring on a wind mill vane and at a rotor casing to provide a spark gap protecting the wind power generation installation from lightning in winter season with a large current for a long duration.

It is an object of the invention to provide EMC protection for towers without inherent EMC shielding capabilities.

This object is solved according to the invention with the features of claims 1 and 2, respectively.

In one aspect the invention is directed to a tower with an EMC protection system. The tower has internal electrical cables and an internal down-conductor and comprises an EMC protection system for electrical cables with an internal down-conductor. The EMC protection system comprises a U-shaped shield with a base portion and two adjoining side portions. The base portion and the side portions define a protected space for the electrical cables. Each side portion of the shield has a length of at least one and a half times, preferably five to ten times, of the thickness of the electrical cables arranged at the base portion. Here, the length of the side portions is significantly larger than the total thickness or height of the layer or layers of cables inside the U-shaped shield. In another aspect of the inventkion, each side portion has a length of at least the length of the base portion so that the length of the side portions depends on the length of the base portion i.e. how open the U-shaped form is towards the surrounding.

A tower with one or more internal down-conductors has an internal electromagnetic field in case of a strike of lightning resulting from the lightning current running through the down-conductor. The EMC protection system shields the electrical cables inside the tower from the electromagnetic or magnetic fields. Electrical or electronic systems in connection with the electrical cables are saved from damage or destruction by the EMC protection system. The EMC protection system offers towers without inherent protection like for example a Faraday cage of a steel tower a good EMC protection of internal electrical cables.

The U-shaped shield offers electromagnetic and magnetic shielding in case of a lightning strike. As the shield does not completely envelop the electrical cables these can be accessed at all time and at all locations e.g. for maintenance. Further, the U-shaped EMC protection shield allows for an easy retrofitting of additional cables to the tower.

The shield may have a length of approximately the height of the tower. This ensures good protection for the electrical cables. The length of the shield may be greater than the height of the tower so that no electromagnetic fields are induced into the cables at the upper and/or lower end of the shield.

The protected space may not be influenced from surrounding electromagnetic fields. The flux lines of the electromagnetic field reach into the U-shaped shield to a certain extent. The area of the U-shaped shield which is free or almost free from the electromagnetic fields is the protected space in which the cables are arranged. The term almost free depends on the actual implementation of the EMC protection system. It means that the electromagnetic fields reaching into the protected space are under a certain threshold which guarantees that no damage occurs to connected systems.

Each side portion of the shield may have a length of at least the length of the base portion of the shield. Preferably, each side portion is higher than the length of the base portion. Both dimensionings ensure a safe distance from the cables to the surrounding electromagnetic fields.

The shield may comprise Al, Cu, Ferrite and/or steel. Other suitable shielding materials may also be used. These materials offer good EMC protection.

The shield may comprise longitudinal sections. The lengths of the side portions of the shield may be different for the longitudinal sections. This allows for a gradual or incremental adaptation of the level of EMC protection over the length of the shield. An adjustment to different protection requirements in different areas, parts or sub-assemblies is possible. For example, if some sections of electrical cables or their surroundings having different EMC characteristics need to be brought to a common EMC protection level the longitudinal sections of the shield will be useful.

The tower may comprise concrete and/or a lattice structure. Concrete or lattice structures are easy and inexpensive to build while being robust at the same time.

The tower may carry or be a wind turbine. Wind turbines often have high towers reaching 100 meters or more. On top of the tower a nacelle is attached which surrounds the electric generator and further electric and electronic equipment. A main shaft carrying a blade hub is also located inside the nacelle. Because of the height and the rotating blades wind turbines are regularly hit by strikes of lightning. Inside the tower of a wind turbine several long cables reach from the ground to the top of the wind turbine which are vulnerable to electromagnetic fields. Further, the wind turbine comprises several sensitive and expensive electric and electronic systems.

The shield of the EMC protection system may also be arranged in a nacelle and/or a hub or further parts of the wind turbine. Preferably, the shield is used in wind turbine components lacking good EMC shielding like non-metallic parts. This allows for EMC protection of the complete wind turbine.

The shield may comprise longitudinal sections with different lengths of the side portions. The longitudinal sections may be assigned to different parts of the wind turbine like the tower, the nacelle or the hub. The different parts of the wind turbine have different electromagnetic characteristics which can be adjusted by the longitudinal sections of the shield to a common level of EMC protection.

The accompanying drawings are included to provide a further understanding of embodiments. Other embodiments and many of the intended advantages will be readily appreciated as they become better understood by reference to the following detailed description. The elements of the drawings do not necessarily scale to each other. Like reference numbers designate corresponding similar parts.

Fig. 1 illustrates a schematic view of a tower equipped with an EMC protection system according to the invention.

Fig. 2 illustrates a schematic view of an EMC protection system according to a first embodiment of the invention.

Fig. 3 illustrates a schematic view of an EMC protection system according to a second embodiment of the invention.

In the following detailed description, reference is made to the accompanying drawings which form a part hereof and in which are shown by way of illustration specific embodiments in which the invention may be practised. In this regard, directional terminology, such as "top" or "bottom" etc. is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

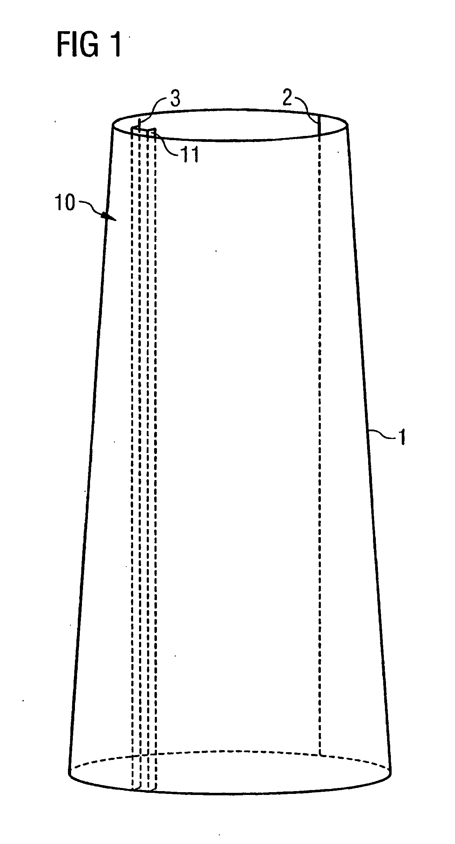

Figure 1 shows a tower 1 made of concrete. The tower may use a lattice or girder structure or a combination of concrete and lattice structure. The tower 1 can be used as a platform for a wind turbine or for telecommunication installations, for example. The tower 1 can reach a height of 100 meters and more. As the tower 1 has a concrete shell it offers no electromagnetic shielding capabilities like a Faraday cage of a steel tower. Therefore, the tower 1 comprises one or more internal down-conductors 2 to conduct current from lightning strikes to the ground.

One or more electrical cables 3 run from the top of the tower 1 to the bottom. The electrical cables 3 convey energy and signals. In case of a wind turbine energy is conveyed in both directions. In case of a strike of lightning to the installations on top of the tower 1 the lightning current is guided by the down-conductor 2 through the tower 1 to the ground. The resulting electromagnetic fields induce high voltages and currents in the electrical cables 3 which could damage or destroy electric and electronic equipment connected with the electrical cables 3.

An electromagnetic compatibility (EMC) protection system 10 is installed in the tower 1 to secure the electrical cables 3 from electromagnetic fields. The EMC protection system 11 has a shield 11 which reaches from the top of the tower 1 to the bottom. The shield 11 can be longer than the height of the tower 1 to avoid induction of fields into the ends of the shield 11. At the bottom the shield 11 may reach into the ground and at the top the shield 11 may extend into an adjacent part.

In case of a wind turbine the shield 11 or a part of the shield 11 may extend into a nacelle arranged on top of the tower 1 and/or even further into a hub carrying the blades.

The shield 11 or parts of the shield 11 may have longitudinal sections with different EMC protection capabilities. This allows for a fine adaptation of the shield 11 to specific EMC protection requirements which vary over the length of the shield 11. Varying EMC protection requirements can occur, for example in different parts of a tower or a wind turbine like tower and nacelle and/or hub. With the help of the longitudinal sections it is possible to set up a common level of EMC protection for different surroundings in a tower, wind turbine or other device.

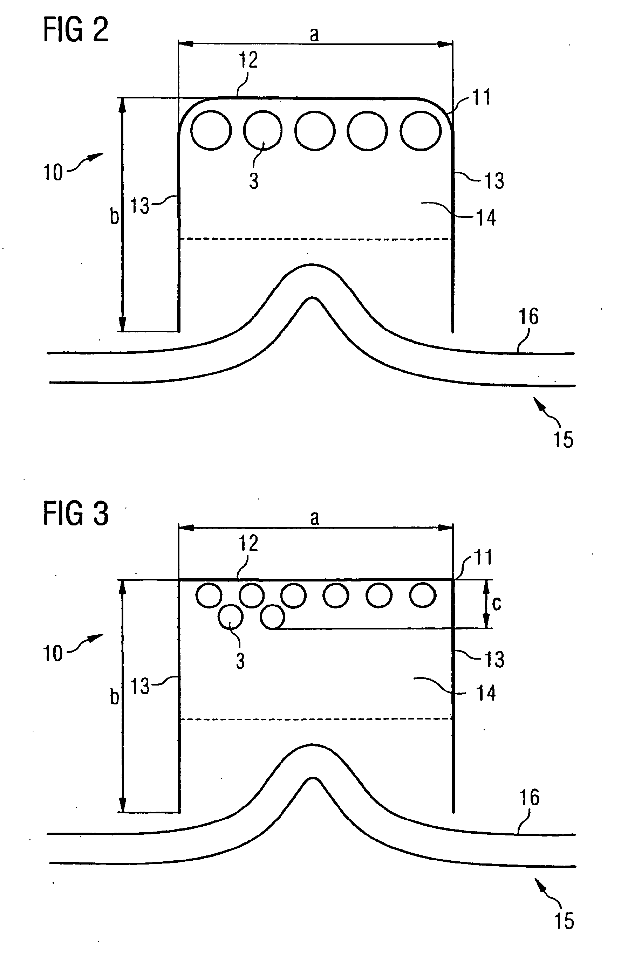

The shield surrounds the electrical cables 3 partially. Figures 2 and 3 show the shield 11 in greater detail.

Figure 2 shows a schematic cross-section of the shield 11 of the EMC protection system 10. The shield 10 has a base portion 12 at which the electrical cables 3 are arranged. The base portion 12 has a length a. At ends of the base portion 12 in longitudinal direction two side portions 13 are arranged. The side portions 13 are substantially parallel. The side portions 13 are integrally formed with base portion 12. It is also possible to mount the base portion 12 and two side portions 13 together to form a shield 11. The shield 11 consists of aluminium, copper, ferrite, steel, other suitable shielding materials or a combination of one or more of these materials.

The base portion 12 and the side portions 13 have a U-shaped form and define an open space in which the electrical cables 3 are arranged. One part of the open space is a protected space 14. The protected space 14 begins at the base portion 12 and stretches along the length of the side portions 13. The end of the protected space 14 is defined on the basis of electromagnetic or magnetic fields 15 reaching into the open space of the shield 11.

Flux lines 16 of the electromagnetic field reach into the open space of the shield 11 as shown in the Figure. The protected space 14 can be defined as the space inside the U-shaped opening of the shield 11 which is free from flux lines 16 of electromagnetic or magnetic fields 15. Another definition is that the protected space 14 is free from electromagnetic or magnetic fields 15 which exceed a certain threshold. In this case electromagnetic or magnetic fields 15 are tolerated inside the protected space 14 if the strength of the field 15 inside the protected space 14 is so low that no damage or destruction can harm electric or electronic systems in communication with the electrical cables 3. In Figure 2 the protected space 14 reaches from the base portion 12 to the dashed line running parallel to the base portion 12.

The size of the protected space 14 depends on the length b of the side portions 13. The longer the side portions 13 are the larger the protected space 14 is. The size of the protected space 14 depends further on the length a of the base portion 12 and the strength of the electromagnetic or magnetic field 15. For a given length a of the base portion 12 the variable to define the size of the protected space is the length b of the side portions 13.

In Figure 2 the length b of each side portion 13 is at least the length a of the base portion 12. This allows for good EMC protection while having good access to the cables 3 at the same time.

The electrical cables 3 are arranged in the protected space 14 close to the base portion 12. The electrical cables can be attached to the base portion 12 by fasteners, clamps, clips or the like. The fasteners can be attached to the base portion 12 or integrally formed with it. The fasteners can also be attached to one or both side portions 13.

Figure 3 shows another embodiment of the EMC protection shield 11 having a similar structure wherein the same reference numerals designate the same parts.

Here, the length b of each side portion 13 is at least one and a half times, preferably five to ten times the thickness c of the one or more electrical cables 3 arranged at the base portion 12 of the shield 11. This dimensioning rule is based upon the payload of the shield 11.

A combination of the dimensioning rules of Figures 2 and 3 is also possible. For example, one can use the length b of the side portion 13 resulting from the dimensioning rule which gives the greater length.

The shield 11 can have several longitudinal sections with different EMC shielding capabilities. The length a of the base portions 12 of different longitudinal sections stays ideally the same while the lengths b of the side portions 13 vary to realize different shielding capabilities. Not only the shielding capabilities can be variable but the dimensioning rules as well. Figure 2 may show the cross-section of one longitudinal section and Figure 3 may show the cross-section of another longitudinal section.

The edges between the base portion 12 and the side portion 13 can be rounded like depicted in Figure 2 or angular as shown in Figure 3. The form of the edge is more likely defined by the production process than by electrical considerations.

The EMC protection system 10 can be mounted into the tower 1 while the tower 1 is build or it can be retrofitted later. The shield 11 of the EMC protection system 10 is attached to an inner surface of the tower 1. For best protection of the electrical cables 3 a space is chosen inside the tower 1 where the electromagnetic or magnetic fields 15 from the down-conductor 2 are as weak as possible. After the shield 11 is fixed to the tower 1 the electrical cables are passed through the shield 11. The cables may be fixed inside the shield 11.

At the upper end of the tower 1 the shield 11 may reach into the next component like a nacelle in case of a wind turbine or the shield 11 ends at the upper end. Another shield or a further part of the shield may be connected to the upper end of the shield 11.

Inspection, repair or later retrofitting of cables can be achieved easily as the shield 11 has an open side. The cables 11 can be accessed without obstacles. The size of the protected space can be planned with reserves so that later on additional cables can be inserted into the protected space 14.

In case of a strike of lightning to the installation mounted on the tower 1 the lightning current is guided to the ground by the down-conductor 2. Inside the tower 1 electromagnetic and magnetic fields 15 are generated by the lightning current. The fields 15 hit the shield 11 where the flux lines 16 of the field 15 are bent as shown in Figures 2 and 3. The flux lines 16 do not enter the protected space 14 so that the electrical cables 3 are shielded. Depending on the characteristics of the system the EMC protection system 10 may be designed to allow entry of weak fields into the protected space 14. This may be easier to build and more inexpensive. The weak fields do not harm or destroy electric or electronic system being in communication with the electrical cables 3.

## Claims

1. A tower, in particular for a wind turbina, comprising an internal down-conductor (2) for guiding a lightning current to the ground and internal electrical cables (3) for conveying energy and signals,
**characterised by**
an EMC protection system (10) for the electrical cables (3) comprising a U-shaped shield (11) in which the cables (3) are arranged, wherein the U-shaped shield (11) comprises a base portion (12) and two adjoining side portions (13), each side portion (13) having a length (b) of at least one and a half times the thickness (c) of the electrical cables (3) arranged at the base portion (12), so that the base portion (12) and the side portions (13) define a protected space (14) for protecting the electrical cables (3) from an electromagnetic field resulting from the flow of lightning current in the down-conductor (2).

2. A tower, in particular for a wind turbina, comprising an internal down-conductor (2) for guiding a lightning current to the ground, internal electrical cables (3) for conveying energy and signals,
**characterised by**
an EMC protection system (10) for the electrical cables (3) comprising a U-shaped shield (11) in which the cables (3) are arranged, wherein the U-shaped shield (11) comprises a base portion (12) and two adjoining side portions (13), each side portion (13) having a length (b) of at least the length (a) of the base portion (12), so that the base portion (12) and the side portions (13) define a protected space (14) for protecting the electrical cables (3) from an electromagnetic field resulting from the flow of lightning current in the down-conductor (2).

3. A tower according to claim 1 or 2, wherein the shield (11) has a length of approximately the height of the tower (1).

4. A tower according to one of claims 1 to 3, wherein the protected space (14) is not influenced from surrounding electromagnetic fields (15).

5. A tower according to one of claims 1, 3 or 4, wherein each side portion (13) has a length (b) of at least the length (a) of the base portion (12).

6. A tower according to one of claims 1 to 5, wherein each side portion (13) has a length (b) of at least one and a half times, preferably five to ten times the thickness (c) of the electrical cables (3) arranged at the base portion (12).

7. A tower according to one of claims 1 to 6, wherein the shield (11) comprises Al, Cu, Ferrite and/or steel.

8. A tower according to one of claims 1 to 7, wherein the shield (11) comprises longitudinal sections and wherein the lengths (b) of the side portions (13) are different for the longitudinal sections.

9. A tower according to one of claims 1 to 8, wherein the tower (1) comprises concrete.

10. A tower according to one of claims 1 to 9, wherein the tower (1) comprises a lattice structure.

11. A tower according to one of claims 1 to 10, wherein the tower (1) carries a wind turbine.

12. A tower according to claim 11, wherein the shield (11) is arranged in a nacelle and/or a hub of the wind turbine.

13. A tower according to claim 12, wherein the shield (11) comprises longitudinal sections with different lengths of the side portions (13) and wherein the longitudinal sections are assigned to different parts of the wind turbine like the tower (1), the nacelle or the hub.

## Patentansprüche

1. Turm, insbesondere für eine Windturbine, welcher einen inneren Ableiter (2) zum Leiten eines Blitzstroms zur Erde und innere elektrische Kabel (3) zum Transportieren von Energie und Signalen umfasst,
**gekennzeichnet durch**
ein EMV-Schutzsystem (10) für die elektrischen Kabel (3), das einen U-förmigen Schirm (11) umfasst, in welchem die Kabel (3) angeordnet sind, wobei der U-förmige Schirm (11) einen Basisabschnitt (12) und zwei angrenzende Seitenabschnitte (13) umfasst, wobei jeder Seitenabschnitt (13) eine Länge (b) aufweist, die mindestens gleich dem Eineinhalbfachen der Dicke (c) der an dem Basisabschnitt (12) angeordneten elektrischen Kabel (3) ist, sodass der Basisabschnitt (12) und die Seitenabschnitte (13) einen geschützten Raum (14) zum Schützen der elektrischen Kabel (3) vor einem elektromagnetischen Feld definieren, das aus dem Fluss von Blitzstrom in dem Ableiter (2) resultiert.

2. Turm, insbesondere für eine Windturbine, welcher einen inneren Ableiter (2) zum Leiten eines Blitzstroms zur Erde und innere elektrische Kabel (3) zum Transportieren von Energie und Signalen umfasst,
**gekennzeichnet durch**
ein EMV-Schutzsystem (10) für die elektrischen Kabel (3), das einen U-förmigen Schirm (11) umfasst, in welchem die Kabel (3) angeordnet sind, wobei der U-förmige Schirm (11) einen Basisabschnitt (12) und zwei angrenzende Seitenabschnitte (13) umfasst, wobei jeder Seitenabschnitt (13) eine Länge (b) aufweist, die mindestens gleich der Länge (a) des Basisabschnitts (12) ist, sodass der Basisabschnitt (12) und die Seitenabschnitte (13) einen geschützten Raum (14) zum Schützen der elektrischen Kabel (3) vor einem elektromagnetischen Feld definieren, das aus dem Fluss von Blitzstrom in dem Ableiter (2) resultiert.

3. Turm nach Anspruch 1 oder 2, wobei der Schirm (11) eine Länge aufweist, die ungefähr gleich der Höhe des Turms (1) ist.

4. Turm nach einem der Ansprüche 1 bis 3, wobei der geschützte Raum (14) nicht von umgebenden elektromagnetischen Feldern (15) beeinflusst wird.

5. Turm nach einem der Ansprüche 1, 3 oder 4, wobei jeder Seitenabschnitt (13) eine Länge (b) aufweist, die mindestens gleich der Länge (a) des Basisabschnitts (12) ist.

6. Turm nach einem der Ansprüche 1 bis 5, wobei jeder Seitenabschnitt (13) eine Länge (b) aufweist, die mindestens gleich dem Eineinhalbfachen, vorzugsweise gleich dem Fünf- bis zehnfachen der Dicke (c) der an dem Basisabschnitt (12) angeordneten elektrischen Kabel (3) ist.

7. Turm nach einem der Ansprüche 1 bis 6, wobei der Schirm (11) Al, Cu, Ferrit und/oder Stahl umfasst.

8. Turm nach einem der Ansprüche 1 bis 7, wobei der Schirm (11) Längsabschnitte umfasst und wobei die Längen (b) der Seitenabschnitte (13) für die Längsabschnitte unterschiedlich sind.

9. Turm nach einem der Ansprüche 1 bis 8, wobei der Turm (1) Beton umfasst.

10. Turm nach einem der Ansprüche 1 bis 9, wobei der Turm (1) eine Gitterstruktur umfasst.

11. Turm nach einem der Ansprüche 1 bis 10, wobei der Turm (1) eine Windturbine trägt.

12. Turm nach Anspruch 11, wobei der Schirm (11) in einer Gondel und/oder einer Nabe der Windturbine angeordnet ist.

13. Turm nach Anspruch 12, wobei der Schirm (11) Längsabschnitte mit unterschiedlichen Längen der Seitenabschnitte (13) umfasst und wobei die Längsabschnitte verschiedenen Teilen der Windturbine zugeordnet sind, wie dem Turm (1), der Gondel oder der Nabe.

## Revendications

1. Tour, notamment pour une éolienne, comprenant un conducteur descendant intérieur (2) pour guider un courant de foudre vers le sol et des câbles électriques internes (3) pour transporter de l'énergie et des signaux,
**caractérisée par** un système de protection CEM (10) pour les câbles électriques (3) comprenant un blindage en forme de U (11) dans lequel les câbles (3) sont disposés, dans laquelle le blindage en forme de U (11) comprend une partie de base (12) et deux parties latérales contiguës (13), chaque partie latérale (13) ayant une longueur (b) égale à au moins une fois et demi l'épaisseur (c) des câbles électriques (3) disposés au niveau de la partie de base (12), de sorte que la partie de base (12) et les parties latérales (13) définissent un espace protégé (14) pour la protection des câbles électriques (3) contre un champ électromagnétique résultant du flux de courant de foudre dans le conducteur descendant (2).

2. Tour, notamment pour une éolienne, comprenant un conducteur descendant intérieur (2) pour guider un courant de foudre vers le sol, des câbles électriques internes (3) pour transporter de l'énergie et des signaux,
**caractérisée par**
un système de protection CEM (10) pour les câbles électriques (3) comprenant un blindage en forme de U (11) dans lequel les câbles (3) sont disposés, dans laquelle le blindage en forme de U (11) comprend une partie de base (12) et deux parties latérales contiguës (13), chaque partie latérale (13) ayant une longueur (b) égale au moins à la longueur (a) de la partie de base (12), de sorte que la partie de base (12) et les parties latérales (13) définissent un espace protégé (14) pour la protection des câbles électriques (3) contre un champ électromagnétique résultant du flux de courant de foudre dans le conducteur descendant (2).

3. Tour selon la revendication 1 ou 2, dans laquelle le blindage (11) a une longueur à peu près égale à la hauteur de la tour (1).

4. Tour selon la revendication 1 à 3, dans laquelle l'espace protégé (14) n'est pas influencé par les champs électromagnétiques environnants (15).

5. Tour selon l'une quelconque des revendications 1, 3 ou 4, dans laquelle chaque partie latérale (13) a une longueur (b) égale au moins à la longueur (a) de la partie de base (12).

6. Tour selon l'une quelconque des revendications 1 à 5, dans laquelle chaque partie latérale (13) a une longueur (b) égale à au moins une fois et demi, de préférence cinq fois à dix fois, l'épaisseur (c) des câbles électriques (3) disposés au niveau de la partie de base (12).

7. Tour selon l'une quelconque des revendications 1 à 6, dans laquelle le blindage (11) comprend Al, Cu, de la ferrite et/ou de l'acier.

8. Tour selon l'une quelconque des revendications 1 à 7, dans laquelle le blindage (11) comprend des sections longitudinales et dans laquelle les longueurs (b) des parties latérales (13) sont différentes pour les sections longitudinales.

9. Tour selon l'une quelconque des revendications 1 à 8, dans laquelle la tour (1) comprend du béton.

10. Tour selon l'une quelconque des revendications 1 à 9, dans laquelle la tour (1) comprend une structure en treillis.

11. Tour selon l'une quelconque des revendications 1 à 10, dans laquelle la tour (1) porte une éolienne.

12. Tour selon la revendication 11, dans laquelle le blindage (11) est situé dans une nacelle et/ou un moyeu de l'éolienne.

13. Tour selon la revendication 12, dans laquelle le blindage (11) comprend des sections longitudinales avec différentes longueurs des parties latérales (13) et dans laquelle les sections longitudinales sont affectées à différentes parties de l'éolienne, telles que la tour (1), la nacelle ou le moyeu.
